(19) Europäisches Patentamt
European Patent Office
Office européen des brevets

(11) **EP 3 451 477 B1**

(12) **EUROPÄISCHE PATENTSCHRIFT**

(45) Veröffentlichungstag und Bekanntmachung des Hinweises auf die Patenterteilung:
**27.05.2020   Patentblatt 2020/22**

(51) Int Cl.:
*H02J 1/08* *(2006.01)*   *H02J 3/36* *(2006.01)*
*H02H 7/26* *(2006.01)*   *G01R 19/25* *(2006.01)*
*G01R 31/08* *(2020.01)*

(21) Anmeldenummer: **18187628.5**

(22) Anmeldetag: **07.08.2018**

(54) **ERKENNEN EINES FEHLERS IN EINEM GLEICHSTROMÜBERTRAGUNGSSYSTEM**

DETECTION OF A FAULT IN A DC TRANSMISSION SYSTEM

DÉTECTION D'UN DÉFAUT DANS UN SYSTÈME DE TRANSMISSION À COURANT CONTINU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.08.2017   DE 102017215006**

(43) Veröffentlichungstag der Anmeldung:
**06.03.2019   Patentblatt 2019/10**

(73) Patentinhaber: **Siemens Aktiengesellschaft 80333 München (DE)**

(72) Erfinder:
• **Derfiora, Rizqa 91052 Erlangen (DE)**
• **Scheibe, Christian 91058 Erlangen (DE)**

(56) Entgegenhaltungen:
**EP-A1- 3 148 029     US-A1- 2013 158 901**

• **PETINO C ET AL: "Intersystem fault clearing in hybrid AC/DC power systems with full bridge modular multilevel converters", 13TH IET INTERNATIONAL CONFERENCE ON AC AND DC POWER TRANSMISSION (ACDC 2017), 16. Februar 2017 (2017-02-16), Seiten 1-6, XP002784916, DOI: 10.1049/cp.2017.0020 ISBN: 978-1-78561-421-7**

## Beschreibung

Die vorliegende Erfindung betrifft ein Verfahren und eine Vorrichtung zum Erkennen eines Fehlers in einem Gleichstromübertragungssystem. Ferner betrifft die vorliegende Erfindung ein Verfahren zum Betreiben eines Gleichstromübertragungssystems und ein Gleichstromübertragungssystem.

Die Hochspannungsgleichstromübertragung (HGÜ) ist ein Verfahren der elektrischen Energieübertragung mit hoher Gleichspannung. Typischerweise wird elektrische Energie in Kraftwerken durch Synchron-Generatoren als Dreiphasenwechselstrom der Frequenz 50 Hz bzw. 60 Hz erzeugt. Die Übertragung großer Leistung erzwingt hohe elektrische Spannungen, um die Verluste bei hohen Strömen zu begrenzen. Bei Wechselspannungsübertragung muss die Blindleistung gering gehalten werden, was zu Problemen führt. Vorteilhaft ist hierbei die Übertragung mit Hochspannungsgleichstrom, weil sich hierbei der Leitungsverlust auf den Ohmschen Widerstand beschränkt, Verluste können bei entsprechend hohen Gleichspannungen gering gehalten werden.

Herkömmlicherweise können zwei oder drei elektrische Leitungen verwendet werden, um eine Hochspannungsgleichstromübertragung zu erlauben. Diese Leitungen können in der Nähe von Hochspannungswechselstromleitungen installiert sein, etwa an gleichen Masten befestigt sein. Dabei können die Hochspannungswechselstromleitungen induktiv mit den Hochspannungsgleichstromübertragungsleitungen gekoppelt sein. Ein (externer) Fehler in einem Wechselstromhochspannungssystem, insbesondere in einer Hochspannungswechselstromleitung, kann daher Störungen in einer Hochspannungsgleichstromübertragungsanlage hervorrufen. Derartige sogenannte Zwischensystemfehler zwischen einer Hochspannungsgleichstromübertragungsanlage und einer Hochspannungswechselstromleitung können eine ernste Gefahr für die Betriebsmittel der Hochspannungsgleichstromübertragungsanlage sein. Daher müssen die HGÜ-Anlagen diese Fehler erkennen und darauf reagieren. Gleichzeitig gilt die Anforderung der Selektivität, das heißt nur so viel abzuschalten, wie im Rahmen der Fehlererkennung nötig ist und dabei den nicht direkt vom Fehler betroffenen Anlagenteil der HGÜ-Anlage ohne nennenswerte Beeinträchtigung weiter Leistung übertragen zu lassen. Bei HGÜ-Anlagen bedeutet dies, nur den betroffenen Pol bei zum Beispiel einem Zwischensystemfehler Hochspannungsleiter-380kV-System abzuschalten.

Bisher wurde bei Zwischensystemfehlern (das heißt bei einer induktiven Störung aufgrund eines externen Fehlers einer Hochspannungswechselstromleitung und einer Leitung der HGÜ-Anlage) die gesamte HGÜ-Anlage abgeschaltet, das heißt aus der Leistungsübertragung herausgenommen. Im Stand der Technik erfolgte keine Erfassung, wo genau der Fehler auftrat.

Typischerweise wurden Voltage Source Converter (VSC)-HGÜ-Anlagen als "symmetrischer Monopol" in Halbbrückentopologie ausgelegt. Das dabei verwendete Zweileitersystem zwang bei jedem DC-seitigen Fehler die Anlage in einen Block-Zustand. Der Konverter hat dann keine Leistung mehr übertragen.

Anlagen, die als Dreileitersystem ausgelegt sind, könnten während des Fehlers weiter Leistung über die nicht vom Fehler betroffenen Leiter übertragen. Dies setzt jedoch voraus, dass der Fehlerort im Falle eines Zwischensystemfehlers schnell eindeutig zugeordnet werden kann, was herkömmlicherweise nicht möglich war.

Aus dem Beitrag von Petino C. et al.: "Intersystem fault clearing in hybrid AC/DC power systems with full bridge modular multilevel converters" ist ein Fehlererkennungsverfahren bekannt, dem eine Untersuchung einer Wechselspannungskomponente in der Gleichspannung des Gleichspannungssystems zugrunde liegt.

In der EP 3 148 029 A1 ist ein Fehlererkennungsverfahren offenbart, bei dem zur Erkennung einer Unsymmetrie eines Fehlers ein Wechselstromsignal in eine DC Leitung eingespeist und untersucht wird.

Somit ist es Aufgabe der vorliegenden Erfindung, ein Verfahren sowie eine Vorrichtung zum Erkennen eines Fehlers in einem Gleichstromübertragungssystem bereitzustellen, wobei insbesondere ein HGÜ-spezifischer bzw. -interner Fehler von einem externen Fehler unterschieden werden kann. Ferner ist es Aufgabe der vorliegenden Erfindung, ein Verfahren zum Betreiben eines Gleichstromübertragungssystems sowie ein Gleichstromübertragungssystem bereitzustellen, welches selbst bei einem Fehler in einer Komponente nicht notwendigerweise die gesamte Anlage abschaltet, so dass weiter zumindest ein Teil von elektrischer Energie übertragen werden kann.

Die Aufgabe wird durch den Gegenstand der unabhängigen Ansprüche gelöst. Die abhängigen Ansprüche spezifizieren besondere Ausführungsformen der vorliegenden Erfindung.

Gemäß einer Ausführungsform der vorliegenden Erfindung ist bereitgestellt ein Verfahren zum Erkennen eines Fehlers in einem Gleichstromübertragungssystem mit einem ersten Leiter, einem neutralen Leiter und einem zweiten Leiter, aufweisend: Bestimmen von jeweiligen Werten einer elektrischen Wechselstromgröße, die dem ersten Leiter, dem neutralen Leiter bzw. dem zweiten Leiter zugeordnet sind; Analysieren der Werte; und Bestimmen ob und wenn welcher Leiter des ersten, zweiten und neutralen Leiters von dem Fehler betroffen ist aus einem Ergebnis des Analysierens.

Ein jeweiliges erstes Ende des ersten Leiters und des neutralen Leiters kann mit einer ersten Polstation verbunden sein und ein jeweiliges zweites Ende des ersten Leiters und des neutralen Leiters kann mit einer zweiten Polstation verbunden sein. Das erste Ende des neutralen Leiters und ein erstes Ende des zweiten Leiters kann mit einer dritten Polstation verbunden sein und das zweite Ende des neutralen Leiters und ein zweites Ende des zweiten Leiters kann mit einer vierten Polstation verbunden sein. Die Polstationen können dabei zum Beispiel einen Transformator umfassen und jeweils einen Konverter. Im Falle der ersten Polstation und der dritten Polstation kann der Konverter ein AC-DC-Konverter sein. Im Falle der zweiten Polstation und der vierten Polstation kann der Konverter ein DC-AC-Konverter sein. Die Konverter können als Voltage Controlled Converter (VCC) ausgelegt sein. Dabei kann jeweils der Konverter drei Reihenschaltungen von Leistungstransistoren bestehend aus jeweils zwei Leistungstransistoren aufweisen. In der Mitte zwischen zwei in Serie geschalteten Leistungstransistoren kann eine Phase für ein Wechselstromsignal bzw. Wechselstromspannung verbunden sein. Die Leistungstransistoren können durch Pulsweitenmodulationssignale, die an ihre jeweiligen Gates geführt werden, gesteuert werden, so dass eine Konvertierung eines Wechselstroms (zum Beispiel 50 Hz oder 60 Hz) in Gleichstrom in dem AC-DC-Konverter erfolgt, und so dass eine Konvertierung eines Gleichstroms in einem Wechselstrom in einem DC-AC-Konverter erfolgt, wie es in herkömmlicher Weise bekannt ist.

Bei dem Fehler kann es sich insbesondere um einen Fehler an einer Komponente des Gleichstromübertragungssystems handeln. Beispielsweise kann ein Kurzschluss zwischen einem der Leiter und einem Wechselspannungsleiter (zum Beispiel einer benachbarten Hochspannungswechselstromleitung) den Fehler bilden. Alternativ kann ein Kurzschluss innerhalb einer der Polstationen vorliegen, zum Beispiel ein Kurzschluss auf einer Wechselstromseite oder auf einer Gleichstromseite gegen Masse. Ferner alternativ kann ein Fehler in einem der Konverter vorliegen. Gemäß Ausführungsformen der vorliegenden Erfindung werden all diese Fehler in dem Gleichstromübertragungssystem von externen Fehlern unterschieden und differenziert, um ein Abschalten bzw. ein Auslösen einer Schutzfunktion bei externen Fehlern vermeiden zu können und die Schutzfunktion nur für die betreffende Komponenten auslösen zu können.

Im Normalbetrieb kann eine Spannung an dem ersten Leiter bei zwischen 300 kV und 500 kV gegenüber Erde liegen und eine Spannung an dem zweiten Leiter kann bei -300 kV bis -500 kV gegen Erde liegen. Somit kann die Energie durch Anlegen des Gleichstroms zwischen dem ersten Leiter und dem zweiten Leiter übertragen werden. Ist einer der Leiter defekt bzw. weist einer der Leiter einen Fehler auf, so kann nichtsdestotrotz auch Energie zwischen dem noch intakten Leiter und dem neutralen Leiter übertragen werden.

Die elektrische Wechselstromgröße kann eine Spannung und/oder ein Strom sein. Die elektrische Wechselstromgröße kann mit geeigneten Messinstrumenten gemessen werden. Die elektrische Wechselstromgröße kann über einen gewissen Zeitraum gemessen werden, um zumindest eine Periode der Wechselspannungsgröße aufzunehmen, insbesondere abzutasten. Im Normalbetriebsfall sollte keiner der Leiter einen Wechselstromanteil führen. Liegt jedoch ein Fehler vor, insbesondere im Zusammenhang mit einem Wechselspannungssystem, so kann einer oder mehrere der Leiter einen Wechselstromanteil führen. Die Wechselstromanteile aller Leiter werden gemäß Ausführungsformen der vorliegenden Erfindung betrachtet und analysiert und/oder verrechnet, um zu erkennen, ob ein externer Fehler oder ein Fehler in dem Gleichstromübertragungssystem vorliegt.

Das Analysieren kann ein logisches/arithmetisches Analysieren bzw. Verrechnen der Werte umfassen. Die Werte der elektrischen Wechselstromgröße können insbesondere Amplituden der elektrischen Wechselstromgröße aufweisen oder umfassen oder sein. Bei einem externen Fehler, beispielsweise von einem benachbarten Hochspannungswechselstromkabel verursacht, welches fehlerhaft ist, kann aufgrund von induktiver Kopplung eine im Wesentlichen symmetrische, das heißt gleiche, Beeinflussung aller drei Leiter des Gleichstromübertragungssystems erfolgen. Sind die jeweiligen Werte aller drei Leiter somit im Wesentlichen gleich groß, so kann auf einen externen Fehler geschlossen werden. Existieren jedoch Unterschiede in der Höhe der Werte, so kann dies auf einen (internen) Fehler des Gleichstromübertragungssystems hinweisen. Somit ist eine effektive Differenzierung zwischen einem externen Fehler und einem Fehler des Gleichstromübertragungssystems ermöglicht, was somit eine gezielte Abschaltung und andererseits ein gezieltes Weiterbetreiben gewisser Komponenten des Gleichstromübertragungssystems erlaubt.

Gemäß der Erfindung umfasst das Analysieren ein Bestimmen, ob einer der Werte größer ist als im Wesentlichen ein Mittelwert der übrigen Werte.

Beispielsweise wird bestimmt, ob einer der Werte um mindestens 5% (oder um mindestens 10% oder 20%) größer ist als der Mittelwert der übrigen Werte. Hier können verschiedene Toleranzbereiche kleiner oder größer als 5% definiert werden. Wenn einer der Werte (wesentlich) größer ist als der Mittelwert der übrigen Werte, so kann geschlossen werden, dass kein externer Fehler vorliegt, welcher eine gleichförmige oder gleiche Beeinflussung aller Werte erwarten ließe. In diesem Fall kann eine Schutzfunktion ausgelöst werden.

Gemäß einer Ausführungsform der vorliegenden Erfindung weist das Verfahren ferner auf Anzeigen, dass derjenige Leiter von dem Fehler betroffen ist, dessen zugeordneter Wert größer ist als im Wesentlichen der Mittelwert der übrigen Werte.

Derjenige Leiter, dessen zugeordneter Wert größer ist als im Wesentlichen der Mittelwert der übrigen Werte, kann der erste Leiter, der zweite Leiter oder auch der neutrale Leiter sein. In diesem Fall kann (nur) für denjenigen Leiter, der von dem Fehler betroffen ist, eine Schutzfunktion ausgelöst werden, ohne Schutzfunktionen für die nicht betroffenen Leiter auszulösen.

Das Verfahren weist ferner auf: Bestimmen, dass kein Leiter von einem Fehler betroffen ist und insbesondere, dass ein externer Fehler vorliegt, wenn keiner der Werte größer ist als im Wesentlichen ein Mittelwert der übrigen Werte. In diesem Fall kann von einer symmetrischen, das heißt gleichen, Beeinflussung aller drei Leiter ausgegangen werden, was aufgrund von einer induktiven Kopplung eines defekten Hochspannungswechselstromkabels hervorgerufen sein kann. In diesem Falle kann das Gleichstromübertragungssystem ohne diesem Falle kann das Gleichstromübertragungssystem ohne Auslösen einer Schutzfunktion und insbesondere ohne ein Abschalten einer Komponente weiter betrieben werden.

Gemäß einer Ausführungsform der vorliegenden Erfindung kann zum Analysieren eine Clarke-Transformation durchgeführt werden, wobei als drei Komponenten einer Eingangsgröße der Clarke-Transformation die drei Werte verwendet werden, um eine erste und eine zweite Komponente der Wechselstromgröße in einem rechtwinkligen Koordinatensystem zu erhalten. Die Clarke-Transformation ist nach Edith Clarke benannt und auch als $\alpha,\beta$-Transformation bezeichnet und dient dazu, mehrphasige Größen in ein einfaches zweiachsiges Koordinatensystem mit den Achsen $\alpha$, $\beta$ zu überführen. Die Drehstromachsen sind typischerweise bezeichnet als U, V, W oder R, S, T. Die Achse U fällt dabei mit der Achse $\alpha$ zusammen. Die Komponenten in Richtung der Achse $\alpha$ und in Richtung der Achse $\beta$, können durch eine Matrixgleichung, das heißt eine lineare Gleichung, aus den Wechselstromkomponenten in Richtungen U, V und W (bzw. R, S, T) berechnet werden. Diese Gleichung berechnet die Komponenten entlang der Richtungen $\alpha$ und $\beta$ durch jeweilige Projektion der dreiphasigen Komponenten U, V, W auf die Achsen $\alpha$ und $\beta$.

Die erste Komponente der Wechselstromgröße in dem rechtwinkligen Koordinatensystem wird zum Beispiel als die Summe aus der ersten Komponente der (3-komponentigen) Eingangsgröße und dem Negativen des Mittelwerts der zweiten und dritten Komponente der Eingangsgröße berechnet. Ist die erste Komponente und auch die zweite Komponente in dem rechtwinkligen Koordinatensystem im Wesentlichen Null, so kann geschlossen werden, dass ein externer Fehler vorliegt.

Gemäß einer Ausführungsform der vorliegenden Erfindung wird, falls festgestellt wird, dass die erste Komponente größer ist als die zweite Komponente in dem rechtwinkligen Koordinatensystem, derjenige Leiter als von dem Fehler betroffen bestimmt, dem die erste Komponente der (3-komponentigen) Eingangsgröße zugeordnet ist.

Hierbei können verschiedene Belegungen vorgenommen werden. Für einen zu betrachtenden bzw. zu untersuchenden Leiter wird der zugeordnete Wert als die erste Komponente der (3-komponentigen) Eingangsgröße definiert und die Berechnung durchgeführt, das heißt bestimmt, ob die erste Komponente in dem rechtwinkligen Koordinatensystem größer ist als die zweite Komponente in dem rechtwinkligen Koordinatensystem (das heißt nach Durchführen der Clarke-Transformation). Die Zuordnung kann für alle Leiter (nacheinander) durchgeführt werden, um alle Leiter separat zu untersuchen bzw. zu diagnostizieren.

Damit ist ein einfaches Verfahren bereitgestellt, eine Fehlerhaftigkeit in einem oder in mehreren der Leiter festzustellen. Es können ein Leiter, zwei Leiter oder auch alle drei Leiter von dem Fehler betroffen sein, wie gemäß einer Ausführungsform der vorliegenden Erfindung festgestellt werden kann.

Gemäß einer Ausführungsform der vorliegenden Erfindung ist die elektrische Wechselstromgröße ein Wechselstrom und/oder eine Wechselspannung bei zum Beispiel 50 Hz oder 60 Hz. Zunächst können alle Ströme aller Leiter untersucht werden, wie oben ausgeführt ist. In einem nächsten Schritt können auch die Spannungen in analoger Weise untersucht werden. Daraus können weitere Eigenschaften des Fehlers bestimmt werden bzw. der Fehler hinsichtlich seiner Ursache weiter eingegrenzt werden.

Gemäß einer Ausführungsform der vorliegenden Erfindung weist das Bestimmen der Werte auf: Messen von Strom und/oder Spannung an den drei Leitern; Filtern des gemessenen Stroms und/oder der Spannung mit einem Bandpass-Filter mit einem Durchlassfenster, welches 50 Hz oder 60 Hz enthält, wobei die Werte den jeweiligen Amplituden des gefilterten Stroms und/oder Spannung entsprechen. Damit können die Werte der Wechselstromgröße für alle Leiter leicht bestimmt werden. Das Verfahren kann dabei weiter aufweisen ein Durchführen einer Clarke-Transformation der gemessenen Ströme und/oder Spannungen vor oder nach dem Filtern. Die Clarke-Transformation kann die dreiphasigen Größen geeignet verrechnen, um eine Diagnose zu erleichtern.

Der Fehler kann dabei umfassen einen Fehler außerhalb einer Polstation, insbesondere Zwischensystem-Fehler zwischen zwei Polstationen, ferner insbesondere galvanischer Kontakt zumindest eines des ersten, des zweiten und des neutralen Leiters mit einem Leiter eines AC-Systems, und/oder einen Fehler innerhalb einer Polstation, insbesondere ein Konverter-Fehler eines AC-DC-Konverters innerhalb einer Polstation, ferner insbesondere Kurzschluss gegen Masse. Der externe Fehler ist ein Fehler in einem benachbarten AC-System, der sich durch induktive Kopplung auf das Gleichstromübertragungssystem auswirken kann.

Gemäß einer Ausführungsform der vorliegenden Erfindung ist bereitgestellt ein Verfahren zum Betreiben eines Gleichstromübertragungssystem mit einem ersten Leiter, einem neutralen Leiter und einem zweiten Leiter, aufweisend: Durchführen eines Verfahrens zum Erkennen eines Fehlers in dem Gleichstromübertragungssystem gemäß einer der vorangehenden Ausführungsformen; und Auslösen einer Schutzfunktion, insbesondere Außer-Betrieb-Nehmen, nur desjenigen oder derjenigen Leiter, die von dem Fehler betroffen bestimmt wurden; Weiterbetreiben desjenigen oder derjenigen Leiter, die nicht von dem Fehler betroffen bestimmt wurden.

Es können verschiedene (leiterspezifische) Schutzfunktionen vorgesehen sein, welche beispielsweise in einer Hierarchie ausgelöst bzw. aufgerufen werden können. Da derjenige oder diejenigen Leiter, die nicht von dem Fehler betroffen bestimmt wurden, weiter betrieben werden, kann weiter zumindest ein Teil von Energie übertragen werden.

Es sollte verstanden werden, dass Merkmale, welche individuell oder in irgendeiner Kombination im Zusammenhang mit einem Verfahren zum Erkennen eines Fehlers in einem Gleichstromübertragungssystem beschrieben, bereitgestellt oder erläutert wurden, ebenso, individuell oder in irgendeiner Kombination auf eine Vorrichtung zum Erkennen eines Fehlers in einem Gleichstromübertragungssystem angewendet werden können, gemäß Ausführungsformen der vorliegenden Erfindung.

Gemäß einer Ausführungsform der vorliegenden Erfindung ist bereitgestellt eine Vorrichtung zum Erkennen eines Fehlers in einem Gleichstromübertragungssystem mit einem ersten Leiter, einem neutralen Leiter und einem zweiten Leiter, aufweisend: ein Messsystem, das ausgebildet ist, jeweilige Werte einer elektrischen Wechselstromgröße, die dem ersten Leiter, dem neutralen Leiter bzw. dem zweiten Leiter zugeordnet sind, zu bestimmen; einen Prozessor, der ausgebildet ist: die Werte zu analysieren, aus einem Ergebnis des Analysierens zu bestimmen, ob und wenn, welcher Leiter des ersten, zweiten und neutralen Leiters von dem Fehler betroffen ist, und zu bestimmen, dass kein Leiter von einem Fehler betroffen ist und insbesondere, dass ein externer Fehler vorliegt, wenn keiner der Werte, insbesondere mindestens um einen Schwellwert, größer ist als im Wesentlichen ein Mittelwert der übrigen Werte, wobei der externe Fehler ein Fehler in einem benachbarten AC-System ist, der sich durch induktive Kopplung auf das Gleichstromübertragungssystem auswirkt.

Die Vorrichtung kann insbesondere ausgebildet sein, ein Verfahren zum Erkennen eines Fehlers in einem Gleichstromübertragungssystem auszuführen, wie es oben in einer Ausführungsform beschrieben ist.

Ferner ist gemäß einer Ausführungsform der vorliegenden Erfindung bereitgestellt ein Gleichstromübertragungssystem mit: einem ersten Leiter; einem neutralen Leiter; einem zweiten Leiter; Polstationen, mit denen Enden der Leiter verbunden sind; und einer Vorrichtung gemäß der vorangehend beschriebenen Ausführungsform.

Ausführungsformen der vorliegenden Erfindung werden nun mit Bezug auf die beiliegenden Zeichnungen erläutert. Die Erfindung ist nicht auf die illustrierten oder beschriebenen Ausführungsformen beschränkt.

Es wird darauf hingewiesen, dass Merkmale bzw. Komponenten von unterschiedlichen Ausführungsformen, die mit den entsprechenden Merkmalen bzw. Komponenten der Ausführungsform nach gleich oder zumindest funktionsgleich sind, mit den gleichen Bezugszeichen oder mit anderen Bezugszeichen versehen sind, welche sich lediglich in der ersten Ziffer und/oder durch einen angehängten Buchstaben von dem Bezugszeichen einer entsprechenden Komponente unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören. Die Erfindung ist jedoch durch die nachfolgenden Ansprüche definiert.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

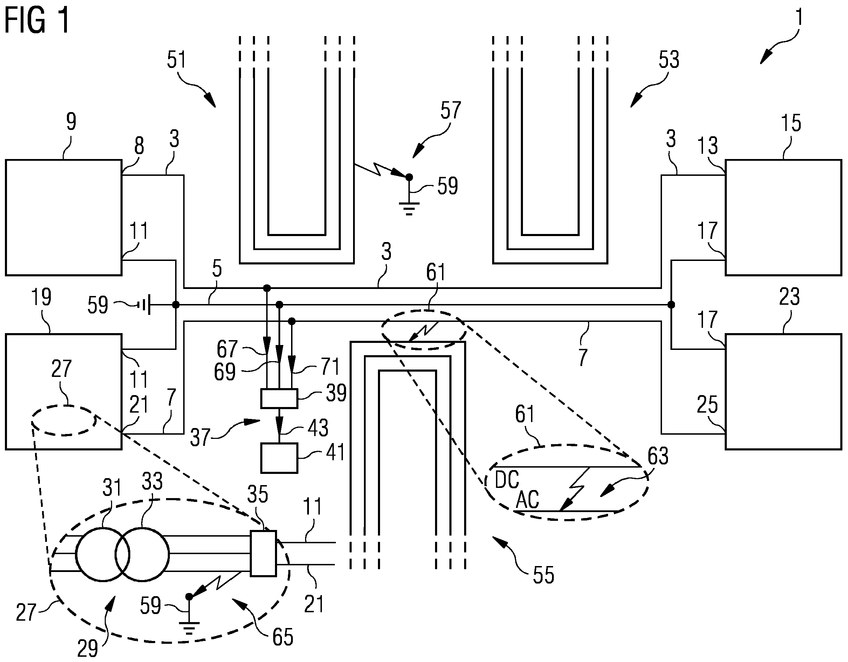

Figur 1 zeigt illustriert schematisch ein Gleichstromübertragungssystem gemäß einer Ausführungsform der vorliegenden Erfindung, welches eine Vorrichtung zum Erkennen eines Fehlers in einem Gleichstromübertragungssystem gemäß einer Ausführungsform der vorliegenden Erfindung umfasst, welche ausgebildet ist, ein Verfahren zum Erkennen eines Fehlers in einem Gleichstromübertragungssystem gemäß einer Ausführungsform der vorliegenden Erfindung durchzuführen;

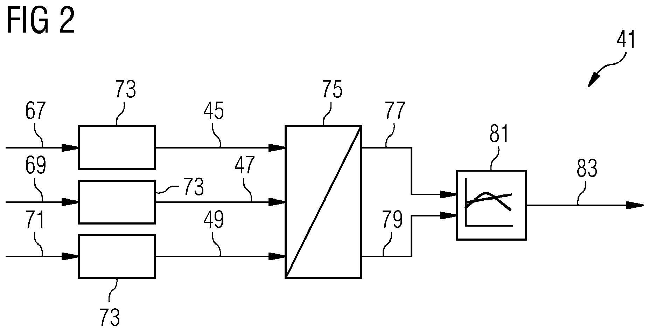

Figur 2 illustriert einen Teil eines Prozessors, wie er in einer Vorrichtung zum Erkennen eines Fehlers in einem Gleichstromübertragungssystem gemäß einer Ausführungsform der vorliegenden Erfindung umfasst sein kann.

Das schematisch in Figur 1 illustrierte Gleichstromübertragungssystem 1 gemäß einer Ausführungsform der vorliegenden Erfindung umfasst einen ersten Leiter 3, einen neutralen Leiter 5 und einen zweiten Leiter 7, welche zur elektrischen Übertragung von Energie mittels Gleichstrom ausgebildet sind. Ein Ende 8 des ersten Leiters 3 ist mit einem ersten Anschluss einer ersten Polstation 9 verbunden, mit einem zweiten Anschluss der ersten Polstation 9 ist ein erstes Ende 11 des neutralen Leiters 5 verbunden ist. Ein zweites Ende 13 des ersten Leiters 3 ist mit einem ersten Anschluss einer zweiten Polstation 15 verbunden, mit einem zweiten Anschluss der zweiten Polstation 15 ist ein zweites Ende 17 des neutralen Leiters 5 verbunden ist. Das erste Ende 11 des neutralen Leiters 5 ist ferner mit einem ersten Anschluss einer dritten Polstation 19 verbunden, mit einem zweiten Anschluss der dritten Polstation 19 ist ein erstes Ende 21 des zweiten Leiters 7 verbunden ist. Das zweite Ende 17 des neutralen Leiters 5 ist mit einem ersten Anschluss einer vierten Polstation 23 verbunden, mit einem zweiten Anschluss der vierten Polstation ist ein zweites Ende 25 des zweiten Leiters 7 verbunden ist.

Die Längen des ersten Leiters 3, des neutralen Leiters 5 und des zweiten Leiters 7 können zum Beispiel zwischen 50 km und 500 km betragen.

Eine Detailansicht 27 eines Teils der dritten Polstation 19 illustriert, dass die Polstation 19 einen Transformator 29 umfassen kann, welchem drei Leiter eines dreiphasigen Energiesignals zugeführt werden. Der Transformator 29 kann eine Spannung auf den mit der Primärspule 31 verbundenen Leitern auf eine höhere Spannung transformieren, welche von einer Sekundärspule 33 abgenommen werden kann. Die Polstation 19 umfasst ferner einen AC-DC-Konverter 35, welcher die Wechselspannung in eine Gleichspannung konvertiert und über die ersten Enden 11 und 21 des neutralen Leiters bzw. des zweiten Leiters 21 führt.

Das Gleichstromübertragungssystem 1 umfasst ferner eine Vorrichtung 37 zum Erkennen eines Fehlers in dem Gleichstromübertragungssystem 1. Die Vorrichtung 37 umfasst dabei ein Messsystem 39, das ausgebildet ist, jeweilige Werte 67, 69, 71 einer elektrischen Wechselstromgröße, die dem ersten Leiter 3, dem neutralen Leiter 5 bzw. dem zweiten Leiter 7 zugeordnet sind, zu bestimmen. Die Vorrichtung 37 umfasst ferner einen Prozessor 41, welchem die Werte als Signal 43 zugeführt werden und welcher ausgebildet ist, die Werte zu analysieren und aus einem Ergebnis des Analysierens zu bestimmen, ob und wenn welcher Leiter des ersten, zweiten und neutralen Leiters von einem Fehler betroffen ist.

Das Messsystem 39 misst dabei einen ersten Wert (repräsentiert durch Signal 67), welcher dem ersten Leiter 3 zugeordnet ist, misst einen zweiten Wert (repräsentiert durch Signal 69), welcher dem neutralen Leiter 5 zugeordnet ist, und misst einen dritten Wert (als Signal 71 repräsentiert), welcher dem zweiten Leiter 7 zugeordnet ist. Die Werte können zum Beispiel Amplituden eines Wechselstroms bzw. einer Wechselspannung sein, wie sie an den jeweiligen Leitern gemessen werden.

Figur 1 illustriert ferner Wechselstromsysteme 51, 53 und 55, welche örtlich benachbart zu dem ersten Leiter 3, dem neutralen Leiter 5 und/oder dem zweiten Leiter 7 angeordnet sein können, beispielsweise in einer Entfernung von zwischen 50 cm und 50 m.

Bei Bezugszeichen 57 ist ein externer Fehler in dem Wechselstromsystem 51 illustriert, beispielsweise ein Kurzschluss eines der Leiter des Wechselstromsystems 51 gegen Masse 59. Der Fehler 57 repräsentiert keinen Fehler des Gleichstromübertragungssystems 1, sondern einen externen Fehler, welcher gemäß Ausführungsformen der vorliegenden Erfindung als ein externer Fehler erkannt werden kann, woraufhin ein Auslösen einer Schutzfunktion oder gar ein Abschalten von Komponenten des Gleichstromübertragungssystems 1 vermieden werden kann oder unterbunden werden kann. Bei dem Fehler 57 kann es sich insbesondere um einen Fehler in einem parallelen AC-System handeln.

In einer Detailansicht 61 ist ein Fehler 63 des Gleichstromübertragungssystems 1 illustriert, nämlich ein Kurzschluss zwischen dem zweiten Leiter 7 und einem Leiter des Wechselspannungssystems 55. Gemäß Ausführungsformen der vorliegenden Erfindung wird in einem Erkennungsverfahren bestimmt, dass der zweite Leiter 7 von dem Fehler betroffen ist, woraufhin eine Schutzfunktion (nur) für den zweiten Leiter 7 ausgelöst werden kann, und woraufhin insbesondere der zweite Leiter 7 von einer Energieübertragung ausgeschlossen werden kann, indem er abgeschaltet wird.

In der Detailansicht 27 ist ein weiterer Fehler 65 der HGÜ, nämlich innerhalb der Polstation 19 illustriert, insbesondere ein Kurzschluss einer hochtransformierten Wechselstromleitung gegen Erde 59, bevor die Wechselspannung von dem Konverter 35 in Gleichspannung konvertiert wird.

Ausführungsformen der vorliegenden Erfindung erlauben, dass die Vorrichtung 37 folgende Unterscheidungen treffen kann:

    1. Liegt der Fehler im zu schützenden Leitungsabschnitt oder nicht? (Abschnittsselektivität)

    2. Liegt der Fehler im zu schützenden Pol oder nicht? (Polselektivität)

    3. Liegt ein Zwischensystemfehler bzw. ein Konverterinterner Fehler vor oder ist der Fehler im parallelen System? (Systemselektivität)

Nur wenn diese drei Faktoren zutreffen, darf oder soll eine Schutzfunktion ausgelöst werden. Ansonsten würde eine Überfunktion vorliegen.

Figur 2 illustriert in schematischer Weise einen Teil des Prozessors 41 der Vorrichtung 37 zum Erkennen eines Fehlers in einem Gleichstromübertragungssystem gemäß einer Ausführungsform der vorliegenden Erfindung. Der Prozessor erhält den ersten Wert 67 einer Wechselstromgröße, insbesondere den Strom, welcher dem ersten Leiter 3 zugeordnet ist. Ferner erhält der Prozessor 51 den Wert 69 der Wechselstromgröße, insbesondere des Stroms, welcher dem neutralen Leiter 5 zugeordnet ist. Ferner erhält der Prozessor den Wert 71 der Wechselstromgröße, insbesondere des Stroms, welcher dem zweiten Leiter 7 zugeordnet ist. Der Prozessor erhält von dem Messsystem 39 somit die Stromwerte 67, 69, 71, die jeweils an dem ersten Leiter 3, dem neutralen Leiter 5 bzw. dem zweiten Leiter 7 gemessen wurden.

Im Fehlerfall haben diese Stromwerte 67, 69, 71 einen Wechselstromanteil. Die Stromwerte werden jeweiligen Filtern 73, insbesondere Bandpassfiltern, zugeführt, welche ausgebildet sind, Frequenzkomponenten um eine Zielfrequenz herum, zum Beispiel 50 Hz oder 60 Hz, passieren zu lassen, während andere Frequenzkomponenten wesentlich abgeschwächt werden. Als Ausgabe werden Werte 45, 47, 49 ausgegeben, welche zum Beispiel den Amplituden von 50 Hz-Komponenten der Ströme 67, 69, und 71, das heißt der Ströme des ersten Leiters 3, des neutralen Leiters 5 und des zweiten Leiters 7 entsprechen können.

Aus einem Analysieren der Werte 45, 47, 49 (oder allgemein der Werte 67, 69, 71) bestimmt das erfindungsgemäße Verfahren, ob und wenn welcher Leiter des ersten, zweiten und neutralen Leiters von dem Fehler betroffen ist. Dazu wird gemäß einer Ausführungsform der vorliegenden Erfindung eine Clarke-Transformation auf den Werten 45, 47, 49 (insbesondere Amplituden von 50 Hz-Schwingungen) durchgeführt, im illustrierten Ausführungsbeispiel mittels eines Transformationsmoduls 75. Mittels einer Clarke-Transformation wird das 3-komponentige Signal mit Komponenten 45, 47, 49 somit in ein 2-komponentiges Signal mit Komponenten 77 und 79 transformiert, welche durch Projektion der dreiphasigen Komponenten 45, 47, 49 auf Achsen eines rechtwinkligen Koordinatensystems bestimmt sind bzw. erhalten werden. Das Signal 77 entspricht dabei dem Strom in Richtung der α-Achse und das Signal 79 entspricht dem Strom entlang der Achse β.

Aus den drei Komponenten IU, IV, IW können z.B. nach folgender Matrixleichung die zwei Komponenten Iα, Iβ in dem rechtwinkligen System berechnet werden:

$$\begin{bmatrix} I_\alpha \\ I_\beta \end{bmatrix} = 2/3 \begin{bmatrix} 1 & -1/2 & -1/2 \\ 0 & \sqrt{3}/2 & -\sqrt{3}/2 \end{bmatrix} \begin{bmatrix} I_U \\ I_V \\ I_W \end{bmatrix}$$

In einem Vergleichsmodul 81 wird die Komponente $I_\alpha$ (Bezugszeichen 77) mit der Stromkomponente $I_\beta$ verglichen, insbesondere unter Berücksichtigung eines Schwellwertes. Stellt sich heraus, dass die Komponente $I_\alpha$ (um mindestens einen Schwellwert) größer ist als die Komponente $I_\beta$ (Bezugszeichen 79), so wird eine Schutzfunktion aufgrund eines binären Ergebnisses 83 ausgelöst, um den entsprechenden Leiter, welcher von dem Fehler betroffen ist, zu schützen, insbesondere abzuschalten.

Um alle Leiter zu diagnostizieren, kann die Belegung der Eingangsgröße für die Clarke-Transformation 75 geändert werden und eine Analyse durchgeführt werden. Insbesondere werden die Eingangssignale des Stroms und der Spannung mittels eines Bandpasses 73 gefiltert. Das Ergebnis ist zum Beispiel der 50 Hz-Wechselanteil der Größen 67, 69, 71. Die gefilterten Größen 45, 47, 49 werden mithilfe einer Clarke-Transformation oder einer vergleichbaren Transformationsmatrix umgewandelt. Aus diesen Größen lässt sich über die Relation zueinander eine Aussage darüber treffen, ob der Fehler im zu betrachtenden Leitungsabschnitt liegt oder nicht. Als Alternative kann die 50 Hz-Filterung auch nach der Transformation erfolgen.

Liegt zum Beispiel die Größe $I_\alpha$ über der Größe $I_\beta$, so wird das Freigabesignal an die eigentliche Schutzfunktion weitergeleitet. Die Schutzfunktion wird damit freigegeben und kann auslösen. Die Freigabe geschieht ausschließlich in den zugehörigen Schutzmodulen, welche zu den entsprechenden Leitungsabschnitten gehören. Die nicht beteiligten Module werden weiterhin blockiert. Das selektive Verfahren benötigt keine Kommunikation bzw. Datenaustausch zwischen den Schutzeinrichtungen an den beiden Enden der Leitung.

Ausführungsformen der vorliegenden Erfindung bieten folgende Vorteile:

Es ist möglich, einen Zwischensystemfehler in einem Bipol-HGÜ-Plus-System festzustellen. Dabei kann schnell eine Aussage darüber getroffen werden, in welchem zu schützenden Abschnitt der Fehler liegt. Dabei kann während der Fehlererklärung das nicht betroffene System weiter Leistung übertragen.

Eine einfache, schnelle und zuverlässige Fehlererkennung ist durch Anwendung einer Transformationsmatrix ermöglicht.

**Patentansprüche**

1. Verfahren zum Erkennen eines Fehlers (63, 65) in einem Gleichstromübertragungssystem (1) mit einem ersten Leiter (3), einem neutralen Leiter (5) und einem zweiten Leiter (7), wobei das Verfahren die folgenden Schritte aufweist:

   Bestimmen von jeweiligen Werten (67, 69, 71, 45, 47, 49) einer elektrischen Wechselstromgröße, die dem ersten Leiter (3), dem neutralen Leiter (5) bzw. dem zweiten Leiter (7) zugeordnet sind;
   Analysieren der Werte (67, 69, 71, 45, 47, 49); und
   Bestimmen ob und wenn ja, welcher Leiter des ersten, zweiten und neutralen Leiters (3, 5, 7) von dem Fehler betroffen ist aus einem Ergebnis (83) des Analysierens,
   **dadurch gekennzeichnet, dass** das Verfahren ferner den folgenden Schritt aufweist: Bestimmen, dass keiner der Leiter (3, 5, 7) von einem Fehler betroffen ist und insbesondere, dass ein externer Fehler (57) vorliegt, wenn keiner der Werte, insbesondere mindestens um einen Schwellwert, größer ist als im Wesentlichen ein Mittelwert der übrigen Werte, wobei der externe Fehler (57) ein Fehler in einem benachbarten AC-System (51) ist, der sich durch induktive Kopplung auf das Gleichstromübertragungssystem (1) auswirkt.

2. Verfahren gemäß Anspruch 1, wobei das Analysieren umfasst:
Bestimmen, ob einer der Werte (67, 69, 71, 45, 47, 49), insbesondere mindestens um den Schwellwert, größer ist als im Wesentlichen ein, insbesondere arithmetischer, Mittelwert der übrigen Werte.

3.  Verfahren gemäß einem der vorangehenden Ansprüche, ferner aufweisend:
Anzeigen, dass derjenige Leiter (3, 5, 7) von dem Fehler betroffen ist, dessen zugeordneter Wert (45, 47, 49), insbesondere mindestens um den Schwellwert, größer ist als im Wesentlichen der Mittelwert der übrigen Werte.

4.  Verfahren gemäß einem der vorangehenden Ansprüche, wobei zum Analysieren eine Clarke-Transformation (75) durchgeführt wird, wobei als drei Komponenten einer Eingangsgröße der Clarke-Transformation die drei Werte (45, 47, 49) der dem ersten, zweiten und neutralen Leiter (3, 5, 7) zugeordneten elektrischen Wechselstromgröße verwendet werden, um eine erste Komponente (77) und eine zweite Komponente (79) der Wechselstromgröße in einem rechtwinkligen Koordinatensystem zu berechnen.

5.  Verfahren gemäß einem der vorangehenden Ansprüche, wobei, falls festgestellt wird, dass die erste Komponente (77) größer ist als die zweite Komponente (79) im rechtwinkligen Koordinatensystem, derjenige Leiter (3, 5, 7) als von dem Fehler betroffen bestimmt wird, dem die erste Komponente (77) der Eingangsgröße zugeordnet ist.

6.  Verfahren gemäß einem der vorangehenden Ansprüche, wobei die elektrische Wechselstromgröße einen Wechselstrom und/oder eine Wechselspannung bei 50 Hz oder 60 Hz umfasst.

7.  Verfahren gemäß einem der vorangehenden Ansprüche, wobei das Bestimmen der Werte aufweist:

Messen von Strom (67, 69, 71) und/oder Spannung an dem ersten, zweiten und neutralen Leiter (3, 5, 7) ;
Filtern (73) des gemessenen Stroms (67, 69, 71) und/oder der Spannung mit einem Bandpass-Filter mit einem Durchlassfenster, welches 50 Hz oder 60 Hz enthält, wobei die Werte den jeweiligen Amplituden des gefilterten Stroms und/oder der gefilterten Spannung entsprechen.

8.  Verfahren gemäß einem der vorangehenden Ansprüche, ferner aufweisend:
Durchführen einer Clarke-Transformation (75) der gemessenen Ströme und/oder Spannungen vor oder nach dem Filtern.

9.  Verfahren gemäß einem der vorangehenden Ansprüche, wobei der Fehler umfasst:

einen Fehler außerhalb einer Polstationen, insbesondere Zwischensystem-Fehler (63) zwischen zwei Polstationen, ferner insbesondere galvanischer Kontakt zumindest eines des ersten, des zweiten und den neutralen Leiters mit einem Leiter eines AC-Systems, und/oder
einen Fehler innerhalb einer Polstationen, insbesondere ein Konverter-Fehler eines AC-DC-Konverters innerhalb einer Polstation, ferner insbesondere Kurzschluss (65) gegen Masse.

10. Verfahren gemäß einem der vorange-henden Ansprüche, wobei das Verfahren ferner die folgenden Schritte aufweist:

Auslösen einer Schutzfunktion, insbesondere Außer-Betrieb-Nehmen, nur desjenigen oder derjenigen Leiter (3, 5, 7), die von dem Fehler betroffen bestimmt wurden;
Weiterbetreiben desjenigen oder derjenigen Leiter (3, 5, 7), die nicht von dem Fehler betroffen bestimmt wurden.

11. Vorrichtung (37) zum Erkennen eines Fehlers (63, 65) in einem Gleichstromübertragungssystem (1) mit einem ersten Leiter (3), einem neutralen Leiter (5) und einem zweiten Leiter (7), das Gleichstromübertragungssystem (1) aufweisend:

ein Messsystem (39), das ausgebildet ist, jeweilige Werte (67, 69, 71, 45, 47, 49) einer elektrischen Wechselstromgröße, die dem ersten Leiter, dem neutralen Leiter bzw. dem zweiten Leiter (3, 5, 7) zugeordnet sind, zu bestimmen;
einen Prozessor, der ausgebildet ist:
die Werte (67, 69, 71, 45, 47, 49) zu analysieren, aus einem Ergebnis (83) des Analysierens zu bestimmen, ob und wenn ja, welcher Leiter des ersten, zweiten und neutralen Leiters (3, 5, 7) von dem Fehler betroffen ist,
**dadurch gekennzeichnet, dass** der Prozessor dazu ausgebildet ist, zu bestimmen, dass keiner der Leiter (3, 5, 7) von einem Fehler betroffen ist und insbesondere, dass ein externer Fehler (57) vorliegt, wenn keiner der Werte, insbesondere mindestens um einen Schwellwert, größer ist als im Wesentlichen ein Mittelwert der übrigen Werte, wobei der externe Fehler (57)ein Fehler in einem benachbarten AC-System (51) ist, der sich durch induktive Kopplung auf das Gleichstromübertragungssystem (1) auswirkt.

12. Gleichstromübertragungssystem (1) mit:

einem ersten Leiter (3);

einem neutralen Leiter (5);
einem zweiten Leiter (7);
Polstationen (9, 15, 19, 23), mit denen Enden des ersten, zweiten und neutralen Leiters (3, 5, 7) verbunden sind; und
einer Vorrichtung (37) gemäß dem vorangehenden Anspruch.

**Claims**

1. Method for identifying a fault (63, 65) in a DC transmission system (1) comprising a first conductor (3), a neutral conductor (5) and a second conductor (7), wherein the method comprises the following steps:

   Determining respective values (67, 69, 71, 45, 47, 49) of an electrical AC variable which are assigned to the first conductor (3), the neutral conductor (5) and the second conductor (7), respectively;
   Analyzing the values (67, 69, 71, 45, 47, 49); and
   Determining whether and, if so, which conductor of the first, second and neutral conductors (3, 5, 7) is affected by the fault from a result (83) of the analyzing,
   **characterized in that** the method furthermore comprises the following step:
   Determining that none of the conductors (3, 5, 7) is affected by a fault and, in particular, that an external fault (57) is present if none of the values is greater, in particular at least by a threshold value, than substantially a mean value of the remaining values, wherein the external fault (57) is a fault in a neighbouring AC system (51) which affects the DC transmission system (1) through inductive coupling.

2. Method according to Claim 1, wherein the analyzing comprises:
   Determining whether one of the values (67, 69, 71, 45, 47, 49) is greater, in particular at least by the threshold value, and substantially an, in particular arithmetic, mean value of the remaining values.

3. Method according to either of the preceding claims, furthermore comprising:
   Indicating that that conductor (3, 5, 7) whose assigned value (45, 47, 49) is greater, in particular at least by the threshold value, than substantially the mean value of the remaining values is affected by the fault.

4. Method according to any of the preceding claims, wherein a Clarke transformation (75) is carried out for the analyzing, wherein the three values (45, 47, 49) of the electrical AC variable assigned to the first, second and neutral conductors (3, 5, 7) are used as three components of an input variable of the Clarke transformation in order to calculate a first component (77) and a second component (79) of the AC variable in a rectangular coordinate system.

5. Method according to any of the preceding claims, wherein, if it is ascertained that the first component (77) is greater than the second component (79) in the rectangular coordinate system, that conductor (3, 5, 7) to which the first component (77) of the input variable is assigned is determined as affected by the fault.

6. Method according to any of the preceding claims, wherein the electrical AC variable comprises an AC current and/or an AC voltage at 50 Hz or 60 Hz.

7. Method according to any of the preceding claims, wherein determining the values comprises:

   Measuring current (67, 69, 71) and/or voltage at the first, second and neutral conductors (3, 5, 7);
   Filtering (73) the measured current (67, 69, 71) and/or the voltage by means of a bandpass filter having a transmission window which includes 50 Hz or 60 Hz,
   wherein the values correspond to the respective amplitudes of the filtered current and/or of the filtered voltage.

8. Method according to any of the preceding claims, furthermore comprising:
   Carrying out a Clarke transformation (75) of the measured currents and/or voltages before or after the filtering.

9. Method according to any of the preceding claims, wherein the fault comprises:

   a fault outside a pole station, in particular intermediate system fault (63) between two pole stations, furthermore in particular galvanic contact between at least one of the first, second and neutral conductors and a conductor of an AC system, and/or
   a fault within a pole station, in particular a converter fault of an AC-DC converter within a pole station, furthermore in particular short circuit (65) with respect to Earth.

10. Method according to any of the preceding claims, wherein the method furthermore comprises the following steps:

    Triggering of a protection function, in particular deactivating, only of that or those conductors (3, 5, 7) which was determined as affected by the fault;

Continuing operation of that or those conductors (3, 5, 7) which were determined as not affected by the fault.

11. Apparatus (37) for identifying a fault (63, 65) in a DC transmission system (1) comprising a first conductor (3), a neutral conductor (5) and a second conductor (7), the DC transmission system (1) comprising:

a measurement system (39) configured to determine respective values (67, 69, 71, 45, 47, 49) of an electrical AC variable which are assigned to the first conductor, the neutral conductor and the second conductor (3, 5, 7), respectively;
a processor configured:

to analyze the values (67, 69, 71, 45, 47, 49), to determine from a result (83) of the analyzing whether and, if so, which conductor of the first, second and neutral conductors (3, 5, 7) is affected by the fault, **characterized in that**
the processor is configured to determine that none of the conductors (3, 5, 7) is affected by a fault and, in particular, that an external fault (57) is present if none of the values is greater, in particular at least by a threshold value, than substantially a mean value of the remaining values, wherein the external fault (57) is a fault in a neighbouring AC system (51) which affects the DC transmission system (1) through inductive coupling.

12. DC transmission system (1) comprising:

a first conductor (3);
a neutral conductor (5);
a second conductor (7);
pole stations (9, 15, 19, 23), to which ends of the first, second and neutral conductors (3, 5, 7) are connected; and
an apparatus (37) according to the preceding claim.

**Revendications**

1. Procédé de détection d'un défaut (63, 65) dans un système (1) de transport de courant continu, comprenant un premier conducteur (3), un conducteur (5) neutre et un deuxième conducteur (7), le procédé ayant les stades suivants :

détermination de valeurs (67, 69, 71, 45, 47, 49) respectives d'une grandeur électrique de courant alternatif, qui sont associées au premier conducteur (3), au conducteur (5) neutre et, respectivement, au deuxième conducteur (7), analyse des valeurs (67, 69, 71, 45, 47, 49) ; et détermination si et, dans l'affirmative, quel conducteur, parmi le premier, deuxième et conducteur (3, 5, 7) neutre, est concerné par le défaut à partir d'un résultat (83) de l'analyse, **caractérisé en ce que** le procédé a, en outre, le stade suivant :
détermination qu'aucun des conducteurs (3, 5, 7) n'est concerné par un défaut et, notamment qu'il y a un défaut (57) extérieur si aucune des valeurs est plus grande, notamment d'au moins une valeur de seuil, que sensiblement une moyenne des autres valeurs, le défaut (57) extérieur étant un défaut dans un système (51) voisin à courant alternatif, qui agit par couplage inductif sur le système (1) de transport de courant continu.

2. Procédé suivant la revendication 1, dans lequel l'analyse comprend :
détermination si l'une des valeurs (67, 69, 71, 45, 47, 49) est plus grande, notamment d'au moins la valeur de seuil, que sensiblement une moyenne, notamment arithmétique, des autres valeurs.

3. Procédé suivant l'une des revendications précédentes, comprenant, en outre :
l'indication que le conducteur (3, 5, 7) concerné par le défaut, est celui dont la valeur (45, 47, 49) associée est plus grande, notamment d'au moins la valeur de seuil, que sensiblement la moyenne des autres valeurs.

4. Procédé suivant l'une des revendications précédents, dans lequel, pour l'analyse, on effectue une transformation (75) de Clarke en utilisant comme trois composantes d'une grandeur d'entrée de la transformation de Clarke, les trois valeurs (45, 47, 49) des grandeurs électriques de courant alternatif associées au premier conducteur (3), deuxième conducteur (7) et conducteur (5) neutre, afin de calculer une première composante (77) et une deuxième composante (79) de la grandeur de courant alternatif dans un système de coordonnées rectangulaire.

5. Procédé suivant l'une des revendications précédentes, dans lequel, si l'on constate que la première composante (77) est plus grande que la deuxième composante (79) dans le système de coordonnées rectangulaire, on détermine que le conducteur (3, 5, 7), qui est affecté par le défaut, est celui auquel est affectée la première composante (77) de la grandeur d'entrée.

6. Procédé suivant l'une des revendications précédentes, dans lequel la grandeur électrique de courant alternatif comprend un courant alternatif et/ou une tension alternative à 50 Hz ou 60 Hz.

7. Procédé suivant l'une des revendications précédentes, dans lequel la détermination des valeurs comprend :

la mesure de courant (67, 69, 71) et/ou de tension sur le premier conducteur (3), deuxième conducteur (7) et conducteur (5) neutre ; le filtrage (73) du courant (67, 69, 71) mesuré et/ou de la tension par un filtre passe-bande ayant une bande passante, qui contient 50 Hz ou 60 Hz,

dans lequel les valeurs correspondent aux amplitudes respectives du courant filtré et/ou la tension filtrée.

8. Procédé suivant l'une des revendications précédentes, dans lequel, en outre :
on effectue une transformation (75) de Clarke des courants et/ou tensions mensurées avant ou après le filtrage.

9. Procédé suivant l'une des revendications précédentes, dans lequel le défaut comprend :

un défaut à l'extérieur d'un poste polaire, notamment un défaut (63) de système intermédiaire entre deux postes polaires, en outre notamment un contact galvanique d'au moins l'un du premier conducteur, du deuxième conducteur et du conducteur neutre avec un conducteur d'un système à courant alternatif et/ou un défaut au sein d'un poste polaire, notamment un défaut d'un convertisseur courant alternatif-continu au sein d'un poste polaire, en outre notamment un court-circuit (65) vis-à-vis de la masse.

10. Procédé suivant l'une des revendications précédentes, le procédé ayant, en outre, le stade suivant :

le déclenchement d'une fonction de protection, notamment une mise hors service seulement du ou des conducteurs (3, 5, 7), qui ont été déterminés comme concernés par le défaut, la continuation du fonctionnement du ou des conducteurs (3, 5, 7), qui ont été déterminés comme n'étant pas concernés par le défaut.

11. Système (37) de détection d'un défaut (63, 65) dans un système (1) de transport de courant continu, comprenant un premier conducteur (3), un conducteur (5) neutre et un deuxième conducteur (7), le système (1) de transport de courant continu comportant :

un système (39) de mesure, constitué pour déterminer des valeurs (67, 69, 71, 45, 47, 49) respectives d'une grandeur électrique de courant alternatif, qui sont associées au premier conducteur, au conducteur neutre et, respectivement, au deuxième conducteur (3, 5, 7), un processeur constitué :

pur analyser les valeurs (67, 69, 71, 45, 47, 49), déterminer, à partir d'un résultat (83) de l'analyse, si, et dans l'affirmative, quel conducteur, parmi le premier conducteur (3), deuxième conducteur (7) et le conducteur (5) neutre, est concerné par le défaut, **caractérisé en ce que** le processeur est constitué pour déterminer qu'aucun des conducteurs n'est concerné par un défaut et, notamment qu'il y a un défaut (57) extérieur, si aucune des valeurs n'est plus grande, notamment d'au moins une valeur de seuil, de sensiblement une moyenne des autres valeurs, le défaut (57) extérieur étant un défaut dans un système (51) à courant alternatif voisin, qui agit par couplage inductif sur le système (1) de transport de courant continu.

12. Système (1) de transport de courant continu, comprenant :

un premier conducteur (3) ; un conducteur (5) neutre ; un deuxième conducteur (7) ; des postes (9, 15, 19, 23) polaires, auxquels les extrémités des premier conducteur (3), deuxième conducteurs (7) et conducteur (5) neutre sont reliés ; et un système (37) suivant la revendication précédente.

FIG 1

FIG 2

**IN DER BESCHREIBUNG AUFGEFÜHRTE DOKUMENTE**

**In der Beschreibung aufgeführte Patentdokumente**

- EP 3148029 A1